# FASCICULE DE BREVET EUROPEEN

(11) **EP 3 048 384 B1**
(45) Date de publication et mention de la délivrance du brevet: **08.04.2020**
(21) Numéro de dépôt: 16151962.4
(22) Date de dépôt: 19.01.2016
(51) Int. Cl.: F23C 3/00, H01L 35/30, F24S 20/40, F24S 20/20

(54) **SYSTÈME DE COMBUSTION PRÉSENTANT UNE TENUE EN TEMPÉRATURE AMÉLIORÉE**
VERBRENNUNGSSYSTEM MIT VERBESSERTER TEMPERATURBESTÄNDIGKEIT
COMBUSTION SYSTEM WITH IMPROVED TEMPERATURE RESISTANCE

(30) Priorité: 20.01.2015 FR 1550451
(43) Date de publication de la demande: 27.07.2016
(73) Titulaire: Commissariat à l'Énergie Atomique et aux Énergies Alternatives, 75015 Paris (FR)
(72) Inventeur: OLLIER, Emmanuel, 38000 GRENOBLE (FR); MANTZARAS, Ioannis, 8037 ZURICH (CH)
(74) Mandataire: Brevalex

(56) Documents cités:
- WO-A1-2014/201116
- FR-A1- 2 995 983
- GB-A- 1 207 275
- US-A- 4 673 348
- US-A1- 2009 220 906
- US-A1- 2014 230 869
- US-B2- 7 862 331

## Description

### DOMAINE TECHNIQUE ET ART ANTÉRIEUR

La présente invention se rapporte à un système de combustion présentant une tenue en température améliorée, à un système solaire hybride comportant au moins un tel système de combustion et à un procédé de fabrication d'un tel système de combustion.

Il existe des dispositifs de production d'électricité comportant un module de combustion et un module thermoélectrique, la face chaude du module thermoélectrique étant en contact avec l'une des faces du module de combustion. En brûlant un ou des gaz dans le module de combustion, la face du module thermoélectrique en contact avec le module de combustion est échauffée, un gradient de température apparaît dans le module thermoélectrique, il y a alors production d'électricité.

Un exemple de tel dispositif est décrit dans le document US 7 862 331.

Le module de combustion comporte une chambre alimentée en gaz par au moins un tuyau d'alimentation, les gaz de combustion sont évacués par au moins un conduit d'évacuation.

Le matériau du module présente une très bonne conductivité thermique puisque l'on souhaite utiliser la chaleur produite dans le module à l'extérieur du module. Dans ce type de module, la température est en générale de l'ordre de 600°C ou inférieure.

Il est d'une part souhaitable de réduire les pertes thermiques de la chambre de combustion vers l'extérieur en dehors de la surface en contact avec le module thermoélectrique, puisqu'on souhaite une température du module la plus élevée possible. Or les tuyaux d'alimentation et d'évacuation, qui sont généralement, en métal, plus particulièrement en acier, peuvent être source de pertes thermiques importantes. De plus, il existe un gradient thermique très important entre la température de l'alimentation en gaz combustible et la température du module.

Or ce gradient thermique génère des contraintes thermomécaniques importantes et peut poser des problèmes de tenue thermomécanique.

Le document GB 1207 275 décrit un système de combustion comportant deux chambres de combustion formées par des tubes distincts suspendus dans un séchoir à bois.

Le document FR2995983 décrit un dispositif solaire hybride comportant une chambre de combustion et un convertisseur thermoélectrique. La mise en œuvre d'une chambre de combustion permet d'assurer une température constante ou un gradient de température constant dans le convertisseur.

Le document WO2014/201116 décrit un échangeur thermique comportant un corps en un matériau conducteur thermique.

### EXPOSÉ DE L'INVENTION

C'est par conséquent un but de la présente invention d'offrir un système de combustion comportant une chambre de combustion d'au moins un gaz combustible et un gaz comburant offrant une tenue en température améliorée.

Le but énoncé ci-dessus est atteint par un système de combustion selon la revendication 1 et par un procédé de fabrication selon la revendication 13. D'autres modes optionnels de réalisation de l'invention sont décrits dans les revendications dépendantes.

Grâce à l'invention, en mettant en œuvre des connecteurs en matériau isolant thermique les contraintes au niveau des extrémités du corps du module sont réduites et, en imposant une circulation à la fois de gaz combustible et comburant et de gaz de combustion dans chaque connecteur, le gradient thermique au sein des connecteurs est réduit, ce qui réduit les contraintes thermomécaniques imposées aux connecteurs et donc réduit le risque de fissures de l'un et/ou de l'autre des connecteurs.

De manière avantageuse, chaque extrémité de la chambre comporte plusieurs entrées d'alimentation et plusieurs sorties d'alimentation ainsi que les connecteurs, les entrées et les sorties étant réparties de sorte qu'au moins deux sorties entourent deux entrées et inversement, ce qui permet de limiter encore le gradient thermique dans les connecteurs.

En d'autres termes, on fait circuler dans chacun des connecteurs à la fois du ou des gaz froids destinés à la combustion et des gaz chauds issus de la combustion, ce qui permet de réduire le gradient thermique par rapport à celui imposé à un connecteur destiné uniquement à l'alimentation dans le cas où la chambre de combustion comporte une extrémité ne comportant que des orifices d'alimentation et une extrémité ne comportant que des orifices destinés à l'évacuation.

Les connecteurs sont par exemple en zircone ou mullite ou alumine et la ou les chambres de combustion sont par exemple réalisées en SiC ou aciers ou Inconel®.

La présente invention a alors pour objet un système de combustion selon les caractéristiques de la revendication 1.

De préférence, le premier connecteur comporte au moins deux conduits d'alimentation connectés à la source d'au moins un gaz combustible et un gaz comburant et au moins deux conduits d'évacuation, lesdits conduits d'alimentation et lesdits conduits d'évacuation étant alternés, et/ou le deuxième connecteur comporte au moins deux conduits d'alimentation connectés à la source d'au moins un gaz combustible et un gaz comburant et au moins deux conduits d'évacuation, lesdits conduits d'alimentation et lesdits conduits d'évacuation étant alternés.

Le module de combustion comporte avantageusement plusieurs chambres de combustion, chaque chambre de combustion étant reliée à un conduit d'alimentation d'un des premier et deuxième connecteurs et à un conduit d'évacuation d'un des deuxième et premier connecteurs.

La source d'au moins un gaz combustible et un gaz comburant peut être un mélange de gaz, par exemple du H₂ et du O₂ ou du H₂ et de l'air.

Par exemple le corps est en SiC et les connecteurs sont en zircone, mullite ou alumine et/ou les tubes reliant la source aux premiers et deuxièmes connecteurs sont en acier haute température ou en alliage Ni-Co.

De préférence, la ou les chambres de combustion comporte(nt) au moins un catalyseur d'allumage.

Dans un exemple de réalisation, le système de combustion comporte des moyens d'emboîtement entre le premier connecteur et le corps et/ou entre le deuxième connecteur et le corps.

Le corps peut présenter sensiblement la forme d'un parallélépipède rectangle comprenant deux faces de plus grande surfaces, connectées par deux faces latérales et deux faces d'extrémité, la au moins une chambre de combustion débouchant dans les faces d'extrémité.

La présente invention a également pour objet un système solaire hybride selon la revendication 10.

La face éclairée par le flux solaire concentrée peut être fonctionnalisée par un absorbeur solaire haute température pour permettre l'échauffement par absorption du rayonnement solaire, par exemple par un absorbeur interférentiel, tel que le TiAlN/AlN/SiO₂ ou un matériau réfractaire nanostructuré tel que le molybdène, le tantale ou le tungstène.

Par exemple, les moyens de conversion comportent au moins une cellule thermophotovoltaïque. La face opposée à celle éclairée par le flux solaire concentré peut être fonctionnalisée avec un émetteur sélectif tel qu'un empilement de W/Al₂O₃ ou de Si/SiO₂ ou tel qu'un matériau réfractaire nanostructuré, tel que le rayonnement infrarouge émis soit dans un domaine de longueur d'onde dans lequel la cellule thermophotovoltaïque présente son meilleur rendement de conversion, tel que le molybdène, le tantale ou le tungstène.

La présente invention a également pour objet un procédé de fabrication selon la revendication 13.

Le procédé de fabrication peut comporter une étape de dépôt d'un catalyseur dans la au moins une chambre de combustion, par exemple par imprégnation en phase liquide ou par dépôt chimique en phase vapeur.

### BRÈVE DESCRIPTION DES DESSINS

La présente invention sera mieux comprise à l'aide de la description qui va suivre et des dessins en annexe, sur lesquels :
- la figure 1 est une vue de dessus représentée schématiquement d'un exemple de réalisation d'un système de combustion,
- les figures 2A et 2B sont des vues de détail de variantes de connexions au niveau d'un connecteur, du corps et des tubes d'alimentation et d'évacuation,
- la figure 3 est une représentation graphique de la variation de température le long d'une direction longitudinale s'étendant entre les deux connecteurs du module du système de la figure 1 et entre les deux connecteurs d'un module dans lequel l'un des connecteurs ne sert qu'à l'alimentation en gaz,
- la figure 4 est une vue de dessus du système de la figure 1 sur laquelle la température au sein du module est symbolisée par des niveaux de gris de manière schématique,
- la figure 5 est une vue de dessus d'un système de combustion qui n'appartient pas à l'invention, dans lequel une extrémité est dédiée à l'alimentation et l'autre extrémité est dédiée à l'évacuation, sur laquelle la température au sein du module est symbolisée par des niveaux de gris de manière schématique, à titre de comparaison avec la figure 4,
- la figure 6 est une représentation schématique d'un système solaire hybride mettant en œuvre le système de combustion,

### EXPOSÉ DÉTAILLÉ DE MODES DE RÉALISATION PARTICULIERS

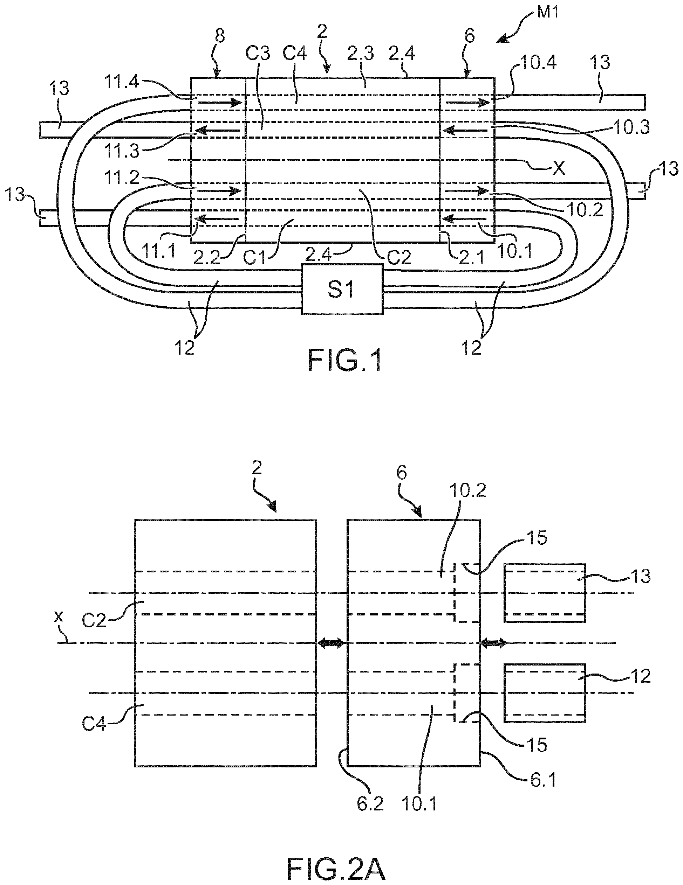

Sur la figure 1, on peut voir un exemple de système de combustion comportant un module de combustion M1 et une source d'au moins un gaz de combustion S1. Le module de combustion M1 comporte un corps 2 comprenant une pluralité de chambres de combustion C1, C2, C3, C4, un premier connecteur 6 et un deuxième connecteur 8.

Selon l'invention, le corps 2 est monobloc, les chambres de combustion étant réalisées dans le corps.

Le corps 2 s'étend le long d'une direction longitudinale X et présente une première face longitudinale 2.1 ou première face d'extrémité 2.1 et une deuxième face longitudinale 2.2 ou deuxième face d'extrémité 2.2. Dans l'exemple représenté, le corps a la forme d'un parallélépipède rectangle. Il comporte en outre des faces supérieures 2.3 et inférieures (non visible) qui présentent une plus grande surface et deux faces latérales 2.4.

Les chambres de combustion C1, C2, C3, C4 s'étendent parallèlement à une direction X.

De préférence, les chambres de combustion C1, C2, C3, C4 sont réparties plus vers l'extérieur dans une direction transversale par rapport à la direction longitudinale X de sorte à compenser les pertes thermiques latérales et de sorte à assurer un échauffement uniforme du corps.

Dans l'exemple représenté, chaque chambre C1, C2, C3, C4 se présente sous la forme d'un canal dont une première extrémité débouche dans la première face 2.1 et dont une deuxième extrémité débouche dans la deuxième face 2.2. De préférence les surfaces de chaque canal de combustion sont recouvertes d'un matériau catalyseur de combustion, comme le platine.

Un module de combustion comportant une seule chambre de combustion et/ou des chambres présentant d'autres formes ne sort pas du cadre de la présente invention.

Le premier connecteur 6 comporte autant de conduits traversant 10.1 à 10.4 que de chambres de combustion C1 à C4, chacun des conduits 10.2 à 10.4 étant destiné à être aligné avec une extrémité d'une chambre de combustion C1 à C4.

Le deuxième connecteur 8 comporte également autant de conduits traversants 11.1 à 11.4 que de chambres de combustion C1 à C4, chacun des conduits 11.1 à 11.4 étant destiné à être aligné avec une autre extrémité d'une chambre de combustion C1 à C4.

Dans l'exemple représenté et de manière préférée, les conduits 10.1 et 10.3 et les conduits 11.2 et 11.4 sont connectés à la source S1 de gaz combustible et de gaz comburant. Les conduits 10.2 et 10.4 et 11.1 et 11.3 sont destinés à évacuer les gaz de combustion.

Dans l'exemple représenté, les conduits des connecteurs sont connectés à la même source de gaz, mais un système avec plusieurs sources de gaz, voire de gaz différents ne sort pas du cadre de la présente invention. Ainsi chacun des premier 6 et deuxième 8 connecteur sert à la fois à l'alimentation des chambres et à l'évacuation de chambres C1-C4.

Les chambres C1 et C3 sont donc alimentées en gaz en vue de la combustion par le connecteur 6 à travers la face 2.1 du corps et les chambres C2 et C4 sont alimentées en gaz en vue de la combustion par le connecteur 8 à travers la face 2.2. Les gaz de combustion des chambres C1 et C3 sont donc évacués par le connecteur 8 et à travers la face 2.2 du module et ceux des chambres C2 et C4 par le connecteur 6 à travers la face 2.1.

Ainsi chaque connecteur 6, 8 est traversé par les gaz de combustion et par le gaz ou les gaz combustibles et le ou les gaz comburants qui sont à une température très inférieure à celle des gaz de combustion. Le gradient thermique à travers chacun des connecteurs est réduit par rapport à celui d'un connecteur servant uniquement à l'alimentation. En outre, en alternant les conduits d'alimentation et d'évacuation il y a une meilleure homogénéité de la température du connecteur dans la direction transversale, ainsi que dans le corps.

De préférence, dans chaque connecteur un conduit d'alimentation alterne avec un conduit d'évacuation, les deux conduits s'équilibrant l'un l'autre, ce qui permet d'obtenir une température encore plus homogène dans la direction transversale.

De préférence, un catalyseur apte à initier la combustion est présent dans les chambres. Il est avantageusement déposé sur la surface intérieure des chambres de combustion. Il peut être par exemple constitué de platine, rhodium ou d'oxydes catalyseurs de combustion.

En variante, la combustion peut également être initiée par un apport extérieur d'énergie comme par exemple une étincelle, une résistance chauffante. Dans le cas d'un module utilisé de façon hybride qui associe à la fois l'énergie solaire et l'énergie issue d'une combustion, l'énergie peut être simplement celle apportée par la concentration du rayonnement solaire sur le corps.

Les premier et deuxième connecteurs sont réalisés en un matériau isolant thermique de sorte qu'ils limitent le transfert de chaleur du module de connexion vers l'extérieur dans la direction X. Le matériau du premier et du deuxième connecteur présentent une conductivité thermique sensiblement inférieure à celle du matériau du corps 2, avantageusement au moins cinq fois inférieure à celle du corps.

Le matériau du premier connecteur peut être le même que celui du deuxième connecteur ou un matériau différent.

On entend dans la présente demande par "matériau isolant thermique" un matériau dont la conductivité thermique à température ambiante est inférieure à 50W/m.K, de préférence inférieure à 10W/m.K.

Le matériau conducteur thermique du corps peut avoir une conductivité thermique à température ambiante supérieure à 30W/m.K.

De préférence, les premier et deuxième connecteurs sont en zircone. En variante on peut prévoir qu'ils soient en oxyde d'aluminium, en mullite ou en tout autre matériau apte à assurer une isolation thermique suffisante.

Le corps est de préférence en SiC. En variante Il peut être en acier, en cordiérite, en alliage par exemple nickel/cobalt.

Des tubes 12 relient la source de gaz combustible et comburant et les chambres de combustion, ils sont connectés aux conduits 10.1 et 10.3 au niveau d'une première face d'extrémité 6.1 du premier connecteur 6, le premier connecteur 6 étant connecté au corps par une deuxième face d'extrémité 6.2.

De même les tubes 12 relient la source de gaz combustible et comburant et les chambres de combustion C1 à C4, ils sont connectés aux conduits 11.2 et 11.4 au niveau d'une première face d'extrémité 8.1 du deuxième connecteur 8, le deuxième connecteur étant connecté au corps par une deuxième face d'extrémité 8.2.

Les gaz d'évacuation sont de préférence collectés dans un réservoir ou guidés vers l'extérieur via des conduits 13 connectés aux conduits 10.2 et 10.4 et 11.1 et 11.3 par les premières faces 6.1 et 8.1 des premier et deuxième connecteurs respectivement.

Les conduits 12 et 13 sont par exemple en acier haute température, ou en alliage tel que les alliages Ni-Co. Du fait de la présence des connecteurs isolants thermiques interposés entre le corps et les tubes d'alimentation 12 en gaz combustible, la température des tubes est réduite par rapport à celle des chambres de combustion C1 à C4 et les risques d'auto-inflammation sont sensiblement réduits. L'isolation thermique procurée par les deux connecteurs 6, 8 est due au matériau isolant thermique et aux dimensions des connecteurs, notamment dans la direction X.

Sur la figure 2A, on peut voir une vue de détail du module de la figure 1 au niveau de la connexion entre le premier connecteur 6 et le corps 2 d'une part, et entre les conduits 10.1 et 10.2 du premier connecteur 6 et les conduits d'alimentation 12 en gaz et les conduits d'évacuation 13 d'autre part.

Dans l'exemple représenté, la deuxième face d'extrémité 6.2 du premier connecteur 6 et la face longitudinale 2.1 du corps sont en appui plan et solidarisées l'une à l'autre de sorte à assurer une connexion étanche entre les alésages 10 et les chambres de combustion C1 et C2. Le corps 2 et le connecteur 6 sont solidarisés les uns aux autres par exemple par soudage ou brasage.

En outre dans l'exemple réalisé, les extrémités des conduits 10.1 et 10.2 débouchant dans la première face d'extrémité 2.1 comportent une portion de plus grand diamètre 15 permettant de loger les extrémités de tubes d'alimentation 12 et les extrémités du tube d'évacuation 13.

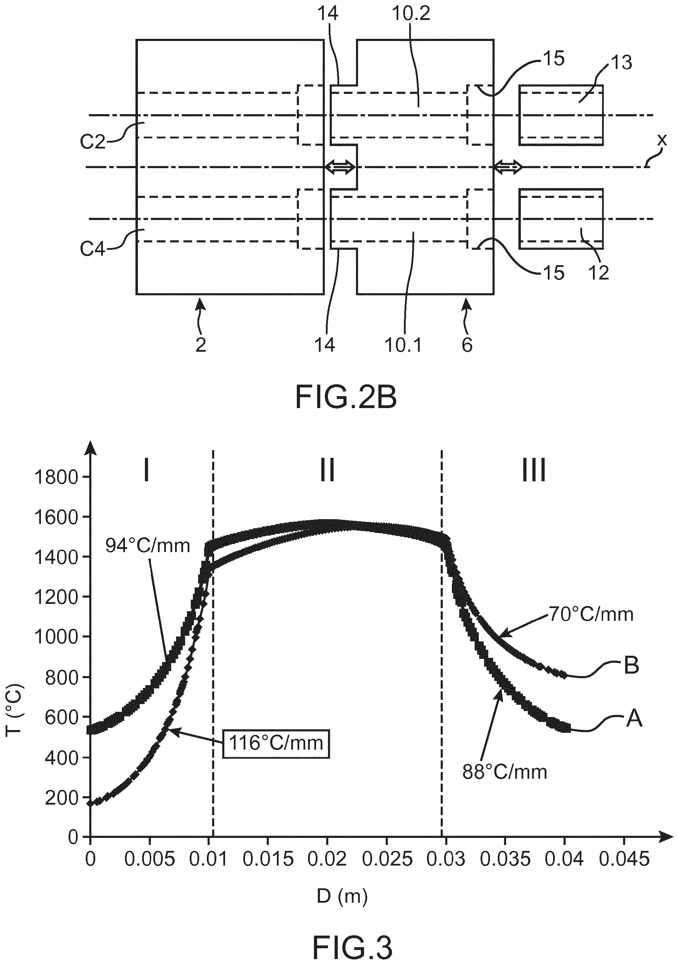

Sur la figure 2B, on peut voir une variante de réalisation du premier connecteur 6 dans laquelle la deuxième face d'extrémité 6.2 comporte des saillies annulaires 14. Chaque saillie annulaire 14 borde une extrémité débouchante des conduits 10.1 et 10.2 dans la face d'extrémité 2.2. Les saillies annulaires 14 pénètrent dans une extrémité des chambres débouchant dans la face d'extrémité 2.1 par emboîtement. L'extrémité de la chambre de combustion a un diamètre suffisant pour recevoir cette saillie annulaire 14. Grâce à cette variante, l'étanchéité de connexion entre le premier connecteur et le corps est améliorée, sa réalisation est simplifiée et l'alignement entre les conduits 10.1 et 10.2 et les chambres C1 et C2 est simplifié. L'assemblage des matériaux est effectué par exemple par une brasure.

Les exemples de connexion entre le premier connecteur 6 et le corps 2 représentés sur les figures 2A et 2B s'appliquent également à la connexion entre le deuxième connecteur 8 et le corps 2.

Par exemple, les chambres de combustion peuvent être alimentées par un mélange H₂/air. En variante elles peuvent être alimentées par un mélange H₂/O₂. En variante encore, les chambres de combustion peuvent être alimentées par un mélange H_{2/}CH_{4/}air, la quantité de CH₄ étant faible par rapport à celle de H₂.

En variante encore, les chambres de combustion peuvent être alimentées par un mélange CH₃OH/air. Il est alors préférable de préchauffer le mélange d'entrée, par exemple à au moins 200°C. Ce préchauffage peut avantageusement être obtenu par l'énergie solaire dans le cas d'un système de combustion mis en œuvre dans un système solaire hybride.

Le gaz combustible et le carburant sont alors mélangés avant d'être acheminés jusqu'aux premier et deuxième connecteurs 6, 8. De manière avantageuse, il peut être prévu que les conduits des connecteurs destinés à l'alimentation comportent des moyens améliorant le mélange des gaz, par exemple une structure poreuse.

Le fonctionnement du module de combustion va être décrit.

Les chambres de combustion C1 et C3 sont alimentées en gaz par les tubes 12 via les conduits 10.1 et 10.3 du premier connecteur 6, et les gaz de combustion sont évacués par les tubes 13 via les conduits 11.1 et 11.3 du deuxième connecteur 8. Les chambres de combustion C2 et C4 sont alimentées en gaz par les tubes 12 via les alésages 11.2 et 11.4 deuxième connecteur 8 et les gaz de combustion sont évacués par les tubes 13 via les conduits 10.2 et 10.4 du premier connecteur 6.

Ainsi chaque connecteur est à la fois traversé par des gaz « froids » provenant de l'extérieur et des gaz chaud provenant des chambres de combustion.

Sur la figure 3, on peut voir deux représentations graphiques de la variation de température T en °C en fonction de la position en m le long de la direction longitudinale X dans un module de combustion, l'origine des abscisses étant la première face d'extrémité 6.1 du premier connecteur 6.

La courbe A est la représentation de la température dans le module M1 de la figure 1 dans lequel l'alimentation et l'évacuation sont croisées et la courbe B est la représentation de la température dans un module dans lequel l'alimentation n'a lieu que par un connecteur et l'évacuation n'a lieu que par l'autre connecteur. La première face d'extrémité du connecteur d'alimentation du module de la courbe B est à l'abscisse 0.

Un mélange air et H₂ est brûlé dans les chambres de combustion.

Les deux connecteurs sont en zircone et ont une dimension dans la direction X de 10 mm et le corps est en SiC et a une dimension dans la direction X de 30 mm, une dimension dans une direction transversale à la direction X de 30 mm et une distance entre la face supérieure et la face inférieure de 5 mm. Le module comporte 4 ou 6 chambres de combustion de 1,5 mm de diamètre.

La zone I correspond sensiblement au premier connecteur 6, la zone II correspond sensiblement au corps 2, la zone III correspond sensiblement au deuxième connecteur 8.

On constate tout d'abord sur la courbe A que les variations de température dans les premier et deuxième connecteurs sont sensiblement symétriques. Dans le premier connecteur 6, la température augmente de 94°C/mm de la première face d'extrémité 6.1 vers le corps 2 et dans le deuxième connecteur 8 elle augmente de 88°C/mm de la première face d'extrémité 8.1 vers le corps 2.

Au contraire sur la courbe B, on constate que le gradient de température est sensiblement plus important dans le connecteur d'alimentation qui ne voit que le gaz destiné à brûler dans les chambres que dans le connecteur d'évacuation. La température varie de 116°C/mm dans le connecteur d'alimentation alors qu'elle varie de 70°C/mm dans le connecteur d'évacuation.

Grâce à l'invention, les deux connecteurs sont soumis à des gradients de température sensiblement identiques ou très proches et de valeurs réduites, ce qui réduit les risques d'endommagement des connecteurs par choc thermique ou simplement liés aux contraintes thermomécaniques générées par les gradients thermiques.

En outre, puisque les deux connecteurs ont les mêmes contraintes thermiques, les risques d'endommagement au sein du module sont réduits. Le module offre donc une plus grande résistance thermomécanique et une plus grande durée de vie du module et donc du système thermique.

En outre, on constate que la température dans le corps du module de la figure 1 est plus élevée que celle dans le module à alimentation et évacuation via des connecteurs distincts. En effet, dans le cas du module M1, la température maximale du module de combustion est de 1756°C et celle de la surface inférieure de 1741°C. Ces deux températures sont sensiblement supérieures à celles du module dans lequel les alimentations et évacuations sont effectuées via des connecteurs distincts, cas pour lequel elles sont respectivement de 1742°C et 1727°C. Ceci est dû au fait que l'établissement d'un gradient de température inférieur entre corps et connecteur permet de limiter légèrement les pertes thermiques et d'obtenir une meilleure uniformité de température du module M1.

On constate également de manière avantageuse que la température au niveau des premières faces d'extrémité 6.1 et 8.1 des premier et deuxième connecteurs 6, 8 respectivement est inférieure à 600°C. Or, il s'agit de la température au-delà de laquelle intervient généralement l'auto-inflammation dans des conditions stœchiométriques. Les risques d'auto-inflammation dans les tubes d'alimentation 12 sont donc réduits voire supprimés.

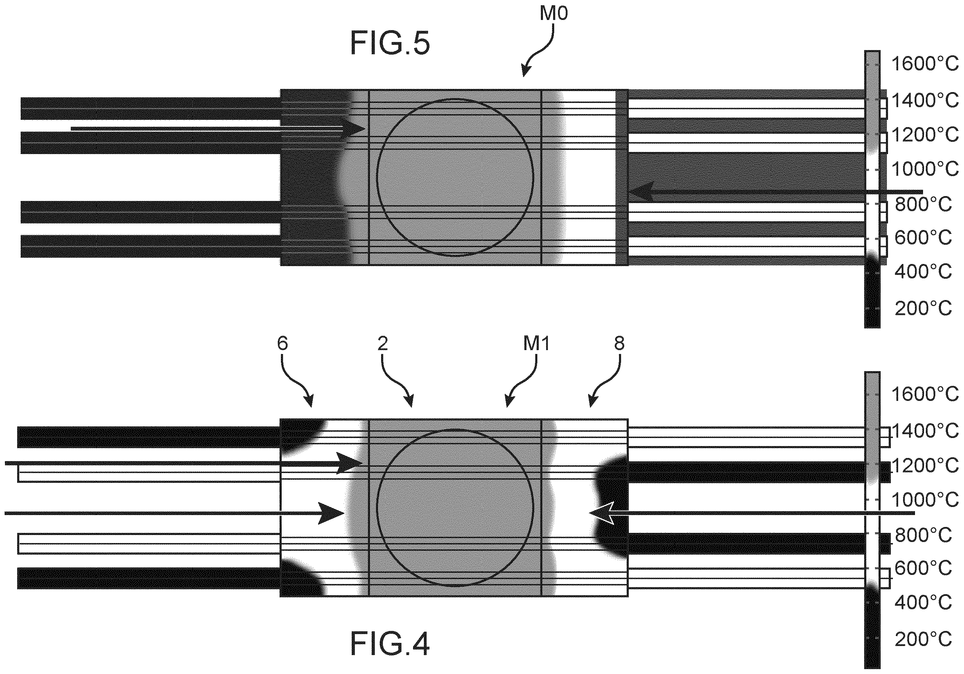

Sur la figure 4 sont représentées de manière schématique les principales zones de température dans le module par des niveaux de gris. On peut voir que le corps 2 du module M1 présente la température la plus élevée, ensuite les deux connecteurs 6, 8 présentent une température relativement homogène dans la direction transversale du fait de la disposition alternée des conduits d'alimentation et d'évacuation. Sur la figure 5, sont représentées par des niveaux de gris les principales zones de température dans le module M0 de la courbe B.

Dans une variante qui n'appartient pas à l'invention, dans les premier et deuxième connecteurs tous les conduits d'alimentation pourraient être regroupés d'un côté et tous les conduits d'évacuation pourraient être regroupés d'un autre côté, le module présenterait une moins bonne homogénéité en température dans la direction transversale mais, néanmoins, les gradients de températures dans les deux connecteurs seraient moindres par rapport à ceux des connecteurs du module de la courbe B.

En variante encore, les conduits d'alimentation et d'évacuation pourraient être regroupés par groupe de 2 ou 3 par exemple, les groupes étant alternés.

Un système de combustion dans lequel les premier et deuxième connecteurs ne sont pas identiques, l'un étant similaire à celui de la figure 1 et l'autre étant similaire à l'une des variantes ci-dessus ne sort pas du cadre de la présente invention.

Dans l'exemple de la figure 1, le corps comporte quatre chambres de combustion. En variante il pourrait ne comporter qu'une seule chambre avec plusieurs entrées d'alimentation et plusieurs sorties d'évacuation réparties dans les deux connecteurs.

De préférence, au moins pour l'application à un système solaire, plusieurs chambres de combustion sont réparties dans un seul plan parallèle aux faces inférieure et supérieure pour assurer une conduction de la chaleur de la face supérieure vers la face inférieure.

Ce module de combustion peut être avantageusement mis en œuvre pour réaliser un système solaire hybride dans lequel la face supérieure est soumise au rayonnement solaire et la face inférieure est en contact avec des modules thermoélectriques, la chaleur produite par la chambre de combustion permettant de compenser les variations d'ensoleillement et d'avoir un fonctionnement sensiblement continu et constant des modules thermoélectriques. En variante, la face inférieure peut être positionnée en regard d'une cellule convertissant le rayonnement infrarouge de la face inférieure en électricité.

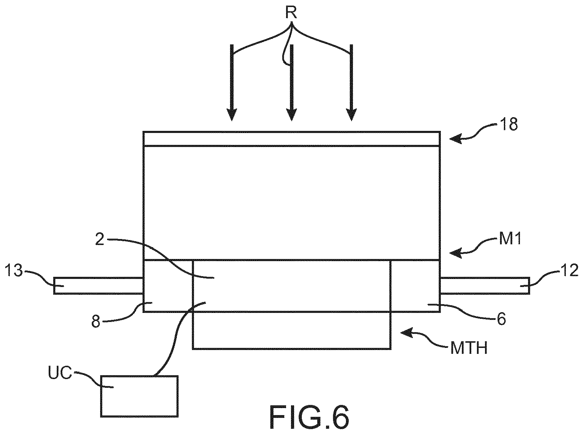

Sur la figure 6, on peut voir une représentation schématique d'un exemple d'un système solaire comportant un module de combustion selon l'invention. Le rayonnement solaire est schématisé par les flèches R.

Le système solaire comporte des moyens de concentration 18 du rayonnement solaire, un module de combustion M1 disposé à l'opposé des moyens de concentration 18 par rapport au soleil de sorte que la face supérieure du corps soit illuminée par le rayonnement solaire concentré et des modules thermoélectriques MTH dont la face chaude est en contact thermique avec la face inférieure du corps du module. En variante, ce module MTH peut comporter une ou plusieurs cellules thermophotovoltaïques placées en face de la face inférieure du module de combustion et transformant le rayonnement infrarouge en électricité.

Le système comporte des moyens de commande UC de la combustion de la chambre en fonctionnement du rayonnement solaire concentré de sorte à maintenir une température sensiblement constante sur la face inférieure du corps du module de combustion ou à en ajuster la valeur de façon à contrôler la puissance électrique fournie par le module.

De préférence, la surface supérieure du module destinée à recevoir le flux solaire concentré, et en particulier la surface supérieure du corps est fonctionnalisée avec un absorbeur solaire haute température pour permettre l'échauffement par absorption du rayonnement solaire. Par exemple il peut s'agir d'un absorbeur interférentiel déposé sur la surface supérieure, tel que le TiAlN/AlN/SiO₂ ou un matériau réfractaire nanostructuré tel que le molybdène, le tantale ou le tungstène.

De préférence, la surface inférieure du module, en particulier la surface inférieure du corps, est fonctionnalisée avec un émetteur sélectif tel qu'un empilement de W/Al₂O₃ ou de Si/SiO₂ ou tel qu'un matériau réfractaire nanostructuré tel que le molybdène, le tantale ou le tungstène.

Les surfaces latérales du module, en particulier celles du corps peuvent avantageusement être fonctionnalisées au moyen d'un matériau à basse émissivité tel qu'un métal réfractaire.

Les moyens de concentration du rayonnement sont par exemple un miroir ou une lentille de Fresnel.

Les modules thermoélectriques peuvent par exemple être remplacés par tout dispositif apte à convertir la chaleur en électricité ou une autre forme d'énergie, comme par exemple les cellules thermophotovoltaïques mentionnées ci-dessus.

Le fonctionnement du système solaire va maintenant être décrit.

Lorsque le rayonnement solaire est suffisant il chauffe le corps du module de combustion en frappant sa face supérieure après avoir été concentré.

La chaleur est transmise par conduction à travers le corps jusqu'à la face inférieure grâce au matériau du corps entre les chambres de combustion, un gradient thermique apparaît alors dans les modules thermoélectriques et de l'électricité est produite.

Si le rayonnement est insuffisant, par exemple en cas de passage nuageux ou en période de nuit, des gaz sont brûlés dans les chambres de combustion, une chaleur est produite, qui complète celle produite par le rayonnement solaire ou pallie son absence. Un gradient thermique apparaît alors dans les modules thermoélectriques et de l'électricité est produite. Dans le cas d'une cellule remplaçant le module thermoélectrique le rayonnement infrarouge est transformé en électricité.

Un exemple de procédé de réalisation va maintenant être décrit.

Le corps et les premier et deuxième connecteurs sont tout d'abord réalisés par usinage.

Lors d'une étape suivante, des perçages sont réalisés dans le corps afin de former les chambres de combustion.

Ensuite les conduits d'alimentation et d'évacuation 10 et 13 sont percés dans les premier et deuxième connecteurs respectivement

Dans le cas où les conduits seraient de forme complexe, les connecteurs peuvent être réalisés par une technologie de moulage par injection de poudre céramique, plus particulièrement la technologie micro-CIM pour mouler par exemple la zircone, l'oxyde d'aluminium, le nitrure de silice, la mullite. Par exemple, la poudre céramique est mélangée avec des composants permettant d'injecter le mélange dans un moule. Ensuite un procédé dit de déliantage permet de retirer du matériau les composants autres que la céramique recherchée. Enfin un recuit à haute température permet de finaliser la réalisation de la pièce en céramique.

Lors d'une étape suivante, le catalyseur de combustion peut être déposé sur la surface intérieure des chambres de combustion par imprégnation liquide ou par dépôt chimique en phase vapeur.

Lors d'une étape suivante le corps et les connecteurs sont solidarisés par exemple par brasage ou par soudage.

Lors d'une étape suivante, les tubes d'alimentation et d'évacuation sont solidarisés aux connecteurs par exemple par soudage ou par brasage.

On peut envisager de solidariser les tubes sur les connecteurs, avant de solidariser les connecteurs au corps.

Comme cela a été décrit ci-dessus, le système de combustion selon l'invention est particulièrement adapté à la réalisation d'un système solaire hybride dans lequel la ou les chambres de combustion permettent de maintenir une température constante en vue d'une conversion thermoélectrique.

Le système de combustion peut être utilisé pour générer de la chaleur sur la base de la microcombution ou mésocombustion.

Une autre application peut être la réalisation de microsystèmes de combustion pour obtenir des microsources de chaleur.

Une autre application peut être la réalisation de microsystèmes de combustion pour des systèmes de micropropulsion.

## Revendications

1. Système de combustion comportant au moins un module de combustion (M1) et au moins une source d'au moins un gaz combustible et un gaz comburant (S1), ledit module de combustion (M1) comportant :
- un corps monobloc comprenant plusieurs chambres de combustion (C1,C2, C3, C4), destinées à être alimentées par la source d'au moins un gaz combustible et un gaz comburant (S1),
- des moyens pour initier la combustion dans les chambres de combustion,
**caractérisé en ce que** le système de combustion comporte en outre :
- un premier connecteur en contact avec une première extrémité du corps, ledit premier connecteur (6) étant en un matériau isolant thermique relativement à celui du corps, ledit premier connecteur comprenant des conduits d'alimentation en gaz combustible et connectés à la source d'au moins un gaz combustible et un gaz comburant (S1), et des conduits d'évacuation en gaz de combustion, le premier connecteur (6) comportant autant de conduits d'alimentation et de conduits d'évacuation que de chambres de combustion,
- un deuxième connecteur (8) en contact avec une deuxième extrémité du corps, ledit deuxième connecteur (8) étant en un matériau isolant thermique relativement à celui du corps, ledit deuxième connecteur comprenant des conduits d'alimentation en gaz combustible et gaz comburant et connectés à la source d'au moins un gaz combustible et un gaz comburant (S1), et des conduits d'évacuation en gaz de combustion, le deuxième connecteur (8) comportant autant de conduits d'alimentation et de conduits d'évacuation que de chambres de combustion.

2. Système de combustion selon la revendication 1, dans lequel le premier connecteur (6) comporte au moins deux conduits d'alimentation (10.1, 10.3) connectés à la source d'au moins un gaz combustible et un gaz comburant et au moins deux conduits d'évacuation (10.2, 10.4), lesdits conduits d'alimentation (10.1, 10.3) et lesdits conduits d'évacuation (10.2, 10.4) étant alternés, et/ou le deuxième connecteur (8) comporte au moins deux conduits d'alimentation (11.2, 11.4) connectés à la source d'au moins un gaz combustible et un gaz comburant et au moins deux conduits d'évacuation (11.1, 11.3), lesdits conduits d'alimentation (11.2, 11.4) et lesdits conduits d'évacuation (11.1, 11.3) étant alternés.

3. Système de combustion selon la revendication 1 ou 2, dans lequel le module de combustion (M1) comporte plusieurs chambres de combustion (C1,C2, C3, C4), chaque chambre de combustion (C1,C2, C3, C4) étant reliée à un conduit d'alimentation d'un des premier (6) et deuxième (8) connecteurs et à un conduit d'évacuation d'un des deuxième (8) et premier (6) connecteurs.

4. Système de combustion selon l'une des revendications 1, 2 ou 3, dans lequel la source d'au moins un gaz combustible et d'un gaz comburant est un mélange de gaz, par exemple du H₂ et du O₂ ou du H₂ et de l'air.

5. Système de combustion selon l'une des revendications 1 à 4, dans lequel le corps est en Sic et les connecteurs sont en zircone, mullite ou alumine.

6. Système de combustion selon l'une des revendications 1 à 5, comportant des tubes reliant la sources aux premier et deuxième connecteurs, lesdits tubes étant en acier haut température ou en alliage Ni-Co.

7. Système de combustion selon l'une des revendications 1 à 6, dans lequel la ou les chambres de combustion (C1, C2, C3, C4) comporte(nt) au moins un catalyseur d'allumage.

8. Système de combustion selon l'une des revendications 1 à 7, comportant des moyens d'emboîtement entre le premier connecteur (6) et le corps (2) et/ou entre le deuxième connecteur (8) et le corps (2).

9. Système de combustion selon l'une des revendications 1 à 8, dans lequel le corps (2) présente sensiblement la forme d'un parallélépipède rectangle comprenant deux faces de plus grande surfaces, connectées par deux faces latérales et deux faces d'extrémité, la au moins une chambre de combustion débouchant dans les faces d'extrémité.

10. Système solaire hybride comportant :
- des moyens de concentration (C) du rayonnement solaire, comportant avantageusement au moins un miroir ou une lentille de Fresnel.
- au moins un système de combustion (MC) selon l'une des revendications 1 à 9, le module du combustion étant disposé de sorte que les rayonnement concentré éclaire une face du corps,
- des moyens de conversion (MTH) d'une énergie thermique en électricité sur une face opposée à celle éclairée par le rayonnement solaire concentré,
- des moyens de commande (UC) de la combustion dans le module de combustion en fonction du rayonnement solaire concentré.

11. Système solaire selon la revendication 10, dans lequel la face éclairée par le flux solaire concentrée est fonctionnalisée par un absorbeur solaire haute température pour permettre l'échauffement par absorption du rayonnement solaire, par exemple par un absorbeur interférentiel, tel que le TiAlN/AlN/SiO₂ ou un matériau réfractaire nanostructuré tel que le molybdène, le tantale ou le tungstène.

12. Système solaire selon la revendication 10 ou 11, dans lequel des moyens de conversion (MTH) comportent au moins une cellule et dans lequel la face opposée à celle éclairée par le flux solaire concentré est fonctionnalisée avec un émetteur sélectif tel qu'un empilement de W/Al₂O₃ ou de Si/SiO₂ ou tel qu'un matériau réfractaire nanostructure, tel que le rayonnement infrarouge émis soit dans un domaine de longueur d'onde dans lequel la cellule présente son meilleur rendement de conversion, tel que le molybdène, le tantale ou le tungstène.

13. Procédé de fabrication d'un système de combustion selon l'une des revendications 1 à 9, comportant les étapes
a) fabrication du corps du module comportant plusieurs chambres de combustion, et mise en place des moyens pour initier la combustion dans les chambres de combustion,
b) fabrication des premier et deuxième connecteurs traversés par des conduits,
c) assemblage des connecteurs sur le corps,
d) connexion des premier et deuxième connecteurs à la source d'au moins un gaz combustible et un gaz comburant.

14. Procédé de fabrication selon la revendication précédente, dans lequel lors de l'étape b) les premier et deuxième connecteurs sont fabriqués par moulage par injection de poudre céramique et/ou lors de l'étape c), l'assemblage des connecteurs sur le corps se fait par soudage ou brasage.

15. Procédé de fabrication selon la revendication 13 ou 14, dans lequel la mise en place des moyens pour initier la combustion comporte une étape de dépôt d'un catalyseur dans les chambres de combustion, par exemple par imprégnation en phase liquide ou par dépôt chimique en phase vapeur.

## Patentansprüche

1. Verbrennungssystem, welches wenigstens ein Verbrennungsmodul (M1) umfasst und wenigstens eine Quelle wenigstens eines brennbaren Gases und eines verbrennungsfördernden Gases (S1), wobei das Verbrennungsmodul (M1) umfasst:
- einen einstückigen Körper, umfassend mehrere Brennkammern (C1, C2, C3, C4), die dazu bestimmt sind, von der Quelle wenigstens eines brennbaren Gases und eines verbrennungsfördernden Gases (S1) gespeist zu werden,
- Mittel zur Auslösung der Verbrennung in den Brennkammern,
**dadurch gekennzeichnet, dass** das Verbrennungssystem ferner umfasst:
- einen ersten Konnektor, der mit einem ersten Ende des Körpers in Kontakt steht, wobei der erste Konnektor (6) aus einem wärmeisolierenden Material in Bezug auf dasjenige des Körpers hergestellt ist, wobei der erste Konnektor Zufuhrleitungen für brennbares Gas aufweist und mit der Quelle wenigstens eines brennbaren Gases und eines verbrennungsfördernden Gases (S1) verbunden ist, sowie Abfuhrleitungen für Verbrennungsgas, wobei der erste Konnektor (6) so viele Zufuhrleitungen und Abfuhrleitungen aufweist, wie es Brennkammern gibt,
- einen zweiten Konnektor (8) in Kontakt mit einem zweiten Ende des Körpers, wobei der zweite Konnektor (8) aus einem wärmeisolierenden Material in Bezug auf dasjenige des Körpers hergestellt ist, wobei der zweite Konnektor Zufuhrleitungen für brennbares Gas und verbrennungsförderndes Gas aufweist und mit der Quelle wenigstens eines brennbaren Gases und eines verbrennungsfördernden Gases (S1) verbunden ist, sowie Abfuhrleitungen für Verbrennungsgas, wobei der zweite Konnektor (8) so viele Zufuhrleitungen und Abfuhrleitungen aufweist, wie es Brennkammern gibt.

2. Verbrennungssystem nach Anspruch 1, wobei der erste Konnektor (6) wenigstens zwei Zufuhrleitungen (10.1, 10.3) umfasst, die mit der Quelle wenigstens eines brennbaren Gases und eines verbrennungsfördernden Gases verbunden sind, und wenigstens zwei Abfuhrleitungen (10.2, 10.4) umfasst, wobei die Zufuhrleitungen (10.1, 10.3) und die Abfuhrleitungen (10.2, 10.4) abwechseln, und/oder wobei der zweite Konnektor (8) wenigstens zwei Zufuhrleitungen (11.2, 11.4), die mit der Quelle wenigstens eines brennbaren Gases und eines verbrennungsfördernden Gases verbunden sind, und wenigstens zwei Abfuhrleitungen (11.1, 11.3) umfasst, wobei die Zufuhrleitungen (11.2, 11.4) und die Abfuhrleitungen (11.1, 11.3) abwechseln.

3. Verbrennungssystem nach Anspruch 1 oder 2, wobei das Verbrennungsmodul (M1) mehrere Brennkammern (C1, C2, C3, C4) umfasst, wobei jede Brennkammer (C1, C2, C3, C4) mit einer Zufuhrleitung eines der ersten (6) und zweiten (8) Konnektoren und mit einer Abfuhrleitung eines der zweiten (8) und ersten (6) Konnektoren verbunden ist.

4. Verbrennungssystem nach einem der Ansprüche 1, 2 oder 3, wobei die Quelle wenigstens eines brennbaren Gases und eines verbrennungsfördernden Gases ein Gemisch aus Gasen, wie beispielsweise H₂ und O₂ oder H₂ und Luft ist.

5. Verbrennungssystem nach einem der Ansprüche 1 bis 4, wobei der Körper aus Sic besteht und die Konnektoren aus Zirkonoxid, Mullit oder Aluminiumoxid bestehen.

6. Verbrennungssystem nach einem der Ansprüche 1 bis 5, umfassend Rohre, die die Quelle mit dem ersten und zweiten Konnektor verbinden, wobei die Rohre aus Hochtemperaturstahl oder einer Ni-Co-Legierung hergestellt sind.

7. Verbrennungssystem nach einem der Ansprüche 1 bis 6, wobei die Brennkammer(n) (C1, C2, C3, C4) wenigstens einen Zündkatalysator enthält (enthalten).

8. Verbrennungssystem nach einem der Ansprüche 1 bis 7, umfassend Mittel zum Einbau zwischen dem ersten Konnektor (6) und dem Körper (2) und/oder zwischen dem zweiten Konnektor (8) und dem Körper (2).

9. Verbrennungssystem nach einem der Ansprüche 1 bis 8, wobei der Körper (2) im Wesentlichen die Form eines rechteckigen Parallelepipeds hat, das zwei Flächen mit größerer Oberfläche aufweist, die durch zwei Seitenflächen und zwei Endflächen verbunden sind, wobei die wenigstens eine Brennkammer in die Endflächen mündet.

10. Hybrides Solarsystem, umfassend:
- Mittel zur Konzentration (C) der Sonnenstrahlung, die vorteilhafterweise wenigstens einen Spiegel oder eine Fresnel-Linse umfassen,
- wenigstens ein Verbrennungssystem (MC) nach einem der Ansprüche 1 bis 9, wobei das Verbrennungsmodul so angeordnet ist, dass die konzentrierte Strahlung eine Fläche des Körpers beleuchtet,
- Mittel zur Konversion (MTH) von Wärmeenergie in Elektrizität an einer Fläche, die der von der konzentrierten Sonnenstrahlung beleuchteten Fläche gegenüberliegt,
- Mittel zur Steuerung (UC) der Verbrennung in dem Verbrennungsmodul in Abhängigkeit von der konzentrierten Sonnenstrahlung.

11. Solarsystem nach Anspruch 10, wobei die durch den konzentrierten Sonnenstrom beleuchtete Fläche durch einen Hochtemperatur-Solarabsorber funktionalisiert ist, um eine Erwärmung durch Absorption der Sonnenstrahlung zu ermöglichen, beispielsweise durch einen Interferenzabsorber wie beispielsweise TiAlN/AlN/Si0₂ oder ein nanostrukturiertes hitzebeständiges Material wie Molybdän, Tantal oder Wolfram.

12. Solarsystem nach Anspruch 10 oder 11, wobei Konversionsmittel (MTH) wenigstens eine Thermophotovoltaikzelle umfassen und wobei die Fläche, die der durch den konzentrierten Sonnenfluss beleuchteten Fläche gegenüberliegt, mit einem selektiven Emitter, wie einem Stapel aus W/Al203 oder Si/Si0₂ oder wie einem nanostrukturierten hitzebeständigen Material, funktionalisiert ist, so dass die emittierte Infrarotstrahlung in einem Wellenlängenbereich liegt, in dem die Thermophotovoltaikzelle ihre beste Konversionseffizienz aufweist, wie beispielsweise Molybdän, Tantal oder Wolfram.

13. Verfahren zur Herstellung eines Verbrennungssystems nach einem der Ansprüche 1 bis 9, umfassend die folgenden Schritte:
a) Herstellen des Körpers des Moduls mit mehreren Brennkammern und Bereitstellen von Mitteln zum Einleiten der Verbrennung in den Brennkammern,
b) Herstellen der ersten und zweiten Konnektoren, durch die sich Leitungen erstrecken,
c) Anbringen der Konnektoren an dem Körper,
d) Verbinden der ersten und zweiten Konnektoren mit der Quelle wenigstens eines brennbaren Gases und eines verbrennungsfördernden Gases.

14. Verfahren zur Herstellung nach dem vorstehenden Anspruch, wobei in Schritt b) die ersten und zweiten Konnektor durch Spritzgießen von Keramikpulver hergestellt werden und/oder in Schritt c) das Anbringen der Konnektoren an dem Körper durch Schweißen oder Löten erfolgt.

15. Verfahren zur Herstellung nach Anspruch 13 oder 14, wobei das Bereitstellen der Mittel zur Auslösung der Verbrennung einen Schritt der Ablagerung eines Katalysators in den Brennkammern, beispielsweise durch Flüssigphasenimprägnierung oder chemische Dampfabscheidung, umfasst.

## Claims

1. Combustion system comprising at least one combustion module (M1) and at least one source of at least one combustible gas and one oxidizing gas (S1), said combustion module (M1) comprising:
- a one-piece body (2) including several combustion chambers (C1, C2, C3, C4) intended to be supplied by the source of at least one combustible gas and one oxidizing gas (S1),
- means for initiating combustion in combustion chambers,
**characterized in that** the combustion system also comprises :
- a first connector (6) in contact with a first end of the body, said first connector (6) being made of a material that is heat insulating relative to that of the body, the first connector including conduits for supplying combustible gas and connected to the source of at least one combustible gas and one oxidizing gas (S1), and conduits for evacuating combustion gas, the first connector (6) including as many conduits for supplying and conduits for evacuating as combustion chambers,
- a second connector (8) in contact with a second end of the body, said second connector (8) being made of a material that is heat insulating relative to that of the body, said second connector (8) including conduits for supplying combustible gas and oxidizing gas and connected to the source of at least one combustible gas and one oxidizing gas (S1), and conduits for evacuating combustion gas, the second connector (8) including as many conduits for supplying and conduits for evacuating as combustion chambers.

2. Combustion system according to claim 1, in which the first connector (6) comprises at least two supply conduits (10.1, 10.3) connected to the source of at least one combustible gas and one oxidizing gas and at least two evacuation conduits (10.2, 10.4), said supply conduits (10.1, 10.3) and said evacuation conduits (10.2, 10.4) being alternating, and/or the second connector (8) comprises at least two supply conduits (11.2, 11.4) connected to the source of at least one combustible gas and one oxidizing gas and at least two evacuation conduits (11.1, 11.3), said supply conduits (11.2, 11.4) and said evacuation conduits (11.1, 11.3) being alternating.

3. Combustion system according to claim 1 or 2, in which the combustion module (M1) comprises several combustion chambers (C1,C2, C3, C4), each combustion chamber (C1,C2, C3, C4) being connected to a supply conduit of one of the first (6) and second (8) connectors and to an evacuation conduit of one of the second (8) and first (6) connectors.

4. Combustion system according to one of claims 1, 2 or 3, in which the source of at least one combustible gas and one oxidizing gas is a mixture of gases, for example H₂ and O₂ or H₂ and air.

5. Combustion system according to one of claims 1 to 4, in which the body is made of SiC and the connectors are made of zirconium oxide, mullite or alumina.

6. Combustion system according to one of claims 1 to 5, comprising tubes connecting the sources to the first and second connectors, said tubes being made of high temperature steel or Ni-Co alloy.

7. Combustion system according to one of claims 1 to 6, in which the combustion chamber(s) (C1, C2, C3, C4) comprise at least one ignition catalyst.

8. Combustion system according to one of claims 1 to 7, comprising insertion means between the first connector (6) and the body (2) and/or between the second connector (8) and the body (2).

9. Combustion system according to one of claims 1 to 8, in which the body (2) has substantially the shape of a rectangular parallelepiped including two faces of larger surfaces, connected by two lateral faces and two end faces, the at least one combustion chamber emerging in the end faces.

10. Hybrid solar system comprising:
- means for concentrating (C) solar radiation advantageously comprising a least one mirror or Fresnel lens,
- at least one combustion system (MC) according to one of claims 1 to 9, the combustion module being located in such manner that the concentrated radiation illuminated a face of the body,
- means for converting (MTH) thermal energy into electricity on a face opposite to that illuminated by the concentrated solar radiation,
- means for controlling (UC) combustion in the combustion module as a function of the concentrated solar radiation.

11. Solar system according to claim 10, in which the face illuminated by the concentrated solar flux is functionalized by a high temperature solar absorber to enable heating by absorption of solar radiation, for example by an interferential absorber, such as TiAlN/AlN/SiO₂ or a nanostructured refractory material such as molybdenum, tantalum or tungsten.

12. Solar system according to claim 10 or 11, in which the conversion means (MTH) comprise at least one thermophotovoltaic cell and in which the face opposite to that illuminated by the concentrated solar flux is functionalized with a selective emitter such as a stack of W/Al₂O₃ or Si/SiO₂ or such as a nanostructured refractory material, such that the infrared radiation emitted is in a wavelength domain in which the thermophotovoltaic cell has its best conversion efficiency, such as molybdenum, tantalum or tungsten.

13. Method of manufacturing a combustion system according to one of claims 1 to 9, comprising the steps of:
a) Manufacture of the body of the module comprising several combustion chamber, and mounting of the means for initiating combustion in the combustion chambers,
b) Manufacture of the first and second connectors crossed through by conduits,
c) Assembly of the connectors on the body,
d) Connection of the first and second connectors to the source of at least one combustible gas and one oxidizing gas.

14. Manufacturing method according to the preceding claim, in which during step b) the first and second connectors are manufactured by injection molding of ceramic powder and/or during step c), the assembly of the connectors on the body takes place by welding or brazing.

15. Manufacturing method according to claim 13 or 14, in which the mounting of the means for initiating combustion comprises a step of depositing a catalyst in the at least one combustion chamber, for example by liquid phase impregnation or chemical vapor deposition.
